# NEUE EUROPÄISCHE PATENTSCHRIFT

(11) **EP 0 228 676 B2**
(45) Veröffentlichungstag und Bekanntmachung des Hinweises auf die Entscheidung über den Einspruch: **10.05.1995**
(45) Hinweis auf die Patenterteilung: 13.03.1991
(21) Anmeldenummer: 86117726.9
(22) Anmeldetag: 19.12.1986
(51) Int. Cl.: G03F 7/32

(54) **Verfahren zur Herstellung von durch Photopolymerisation vernetzten Reliefformen**
Process for obtaining relief forms reticulated by means of photopolymerization
Procédé pour la fabrication de formes en relief réticulées par photopolymérisation

(30) Priorität: 04.01.1986 DE 3600116
(43) Veröffentlichungstag der Anmeldung: 15.07.1987
(73) Patentinhaber: BASF Aktiengesellschaft, 67063 Ludwigshafen (DE)
(72) Erfinder: Hoffmann, Gerhard, Dr., D-6701 Otterstadt (DE); Kurtz, Karl-Rudolf, Dr., D-6900 Heidelberg (DE)

(56) Entgegenhaltungen:
- EP-B- 0 027 932
- EP-B- 0 111 799
- DE-A- 40 774
- DE-A- 62 662
- DE-A- 2 223 808
- DE-A- 3 315 118
- DE-A- 3 543 961
- FR-A- 474 142
- GB-A- 1 395 822
- US-A- 1 574 357
- US-A- 1 575 143
- US-A- 1 587 269
- US-A- 1 587 272
- US-A- 1 587 273
- US-A- 1 587 273
- US-A- 1 791 908
- US-A- 1 797 210
- US-A- 1 797 211
- US-A- 3 887 373
- US-A- 4 323 636
- US-A- 4 339 530
- US-A- 4 517 279
- CHEMICAL ABSTRACTS, Band 102, Nr. 2, Januar 1985, Seite 576, Zusammenfassung Nr. 15282s, Columbus, Ohio, US; & SU-A-1 113 774
- J.M. EDER: "Ausführliches Handbuch der Photographie", Band 4, 2. Auflage, Heft 4: "Die Photographischen Copienverfahren mittels Mangan-, Cobalt-, Cerium-, Vanadium-, Blei- und Zinnsalzen und Asphalt", 81. Kapitel, 1899, Seiten 576-597, W. Knapp, Halle A/S, DE;
- FORTSCHRITTE DER CHEMISCHEN FORSCHUNG, Band 13/2, 1969, Seiten 227-250, Springer Verlag, Berlin, DE; J.L.R. WILLIAMS: "Photopolymerization and photocrosslinking of polymers"
- O. KRÜGER: "Die Lithographischen Verfahren und der Offsetdruck", 2. Auflage, 1929, Seiten 84-87, F.A. Brockhaus, Leipzig, DE;
- J.M. EDER: "Ausführliches Handbuch der Photographie", 1. Heft: "Die chemischen Wirkungen des Lichtes und die Photographie", 1882, 1. Kapitel, Seiten 1-9, 2. Kapitel, Seiten 10-35, W. Knapp, Halle A/S, DE;
- Hercules Review "Monocyclic Terpene Hydrocarbons" und "Blended Terpene Solvents", Hercules Powder Company (1942), S. 10-16
- Shell Industrial Chemicals Technical Bulletin ICS (X)/79/2
- Shell Industrial Chemicals Technical Bulletin ICS/78/1
- Shell Industrial Chemicals Technical Bulletin ICS/78/2
- Marsden Solvent Guide (1963), Seiten 604, 605 und acht weitere nicht numerierte Seiten
- Extrakt (zwei Seiten) aus Texaco "Solvent Properties" Guide (1990)
- Patent Abstracts of Japan, Bd 7, Nr. 180 (P-215), S. 16, 09.08.83 & JP-A-58 08 2244
- Römpps Chemie-Lexikon, 8. Auflage (1981), Bd. 2, S. 875
- Römpps Chemie-Lexikon, 8. Auflage (1985), Bd. 4, S. 2713

## Beschreibung

Die Erfindung betrifft ein verbessertes Verfahren zur Herstellung von durch Photopolymerisation vernetzten Reliefformen durch bildmäßiges Belichten von durch Photopolymerisation vernetzbaren Schichten mit aktinischem Licht und Auswaschen der unvernetzten Anteile der Schichten mit Entwicklerlösungsmitteln, wobei diese Schichten in der Hauptsache ein oder mehrere Bindemittel A auf der Basis elastomerer Polymerisate, ein oder mehrere hiermit verträgliche photopolymerisierbare Monomere B und einen oder mehrere Photoinitiatoren C enthalten. Außerdem betrifft die Erfindung Relief-formen mit verbesserter Relieftiefe und verbessertem Flankenaufbau.

Ein solches Verfahren ist, sieht man von der erfindungsgemäßen Verbesserung ab, allgemein bekannt. Ublicherweise werden dabei als Entwicklerlösungsmittel
a) chlorierte Kohlenwasserstoffe wie Chloroform, Trichlorethylen, Tetrachlorethylen oder Trichlorethan als solche oder als Gemische mit niederen Alkoholen wie n-Butanol;
b) gesättigte cyclische und acyclische Kohlenwasserstoffe wie Petrolether, Hexan, Heptan, Octan, Cyclohexan oder Methylcyclohexan;
c) aromatische Kohlenwasserstoffe wie Benzol, Toluol oder Xylol; oder
d) niedere aliphatische Ketone wie Aceton, Nethylethylketon oder Hethylisobutylketon
   verwendet.

Nachteilig für die bekannten Verfahrensweisen ist, daß man die Entwicklerläsungsmittel lange einwirken lassen muß, um eine befriedigende Auswaschwirkung zu erzielen. Dabei werden die Reliefformen häufig angequollen oder Teile des Reliefs werden unterwaschen und unter Umständen mechanisch abgelöst. Außerdem sind bei der Verwendung üblicher, gesättigter oder aromatischer Kohlenwasserstoffe und Ketone lange Trocknungszeiten notwendig, und häufig kommt es dabei zur gefürchteten "positiven inneren Zurichtung", d.h. feinere Bildelemente ragen über das Niveau von Volltonflächen heraus. Nichtzuletztweisen diese Lösungsmittel niedrige Flammpunkte von kleiner als 21 °C auf, so daß das Verfahren nur in besonderen, explosionsgeschützten Anlagen betrieben werden kann. Bei der Verwendung chlorierter Kohlenwasserstoffe führt deren Toxizität zu Ent sorgungsproblemen. Außerdem weisen Reliefformen, die mit Hilfe dieser Lösungsmittel hergestellt wurden, einen unbefriedigenden Flankenaufbau aus.

Darüber hinaus ist es aus den Patentschriften US-A-1 751 908, US-A1 587 272, US-A-1 574 357, US-A-1 587 269, DE-A-40 724, FR-A-47 412 und US-A-1 587 273 sowie der Publikation von 0. Krüger "Die lithographischen Verfahren und der Offsetdruck", 2. Auflage, 1929, Seite 86, Zeilen 3 bis 23, und der Publikation "Fortschritte der chemischen Forschung", Band 13/2, 1969, Seite 229, letzter Absatz 2, bekannt, Benzin, Naphtha und Terpentin, das in der Hauptsache Monoterpene wiea - und β-Pinen enthält, als Entwicklerlösungsmittel zur Herstellung von Reliefformen aus photopolymerisierbaren Schichten zu verwenden. Allerdings handelt es sich bei diesen Schichten nicht um solche der eingangs genannten Art, welche in der Hauptsache die Bestandteile A, B und C enthalten.

Aufgabe dervorliegenden Erfindung wares, ein Verfahren zur Herstellung von durch Photopolymerisation vernetzten Reliefformen aus durch Photopolymerisation vernetzbaren Schichten, die in der Hauptsache die eingangs genannten Bestandteile A, B und C enthalten, zu finden, bei dem die Auswaschzeit und die Trockenzeit gegenüber dem bekannten Verfahren deutlich kürzer ist, die Reliefformen weder angequollen noch unterwaschen werden und keine "positive innere Zurichtung" eintritt und das ohne aufwendigen Explosionsschutz betrieben werden kann und Reliefformen mit verbesserter Relieftiefe und verbessertem Flankenaufbau liefert.

Demgemäß wurde ein Verfahren zur Herstellung von durch Photopolymerisation vernetzten Flexodruckform gefunden, bei dem man durch Photopolymerisation vernetzbare Schichten von Flexodruckplatten mit aktinischem Licht bildmäßig belichtet und die unvernetzten Anteile der Schichten mit Entwicklerlösungsmitteln auswäscht, wobei diese Schichten in der Hauptsache
A) ein oder mehrere Bindemittel auf der Basis elastomerer Polymerisate,
B) ein oder mehrere hiermit verträgliche photopolymerisierbare Monomere und
C) einen oder mehrere Photoinitiatoren enthalten,
   und das dadurch gekennzeichnet ist, daß man Entwicklerlösungsmittel verwendet, die als wesentlichen Bestandteil Monoterpene enthalten.

Erfindungsgemäß mit besonderem Vorteil anzuwendende Monoterpene sind 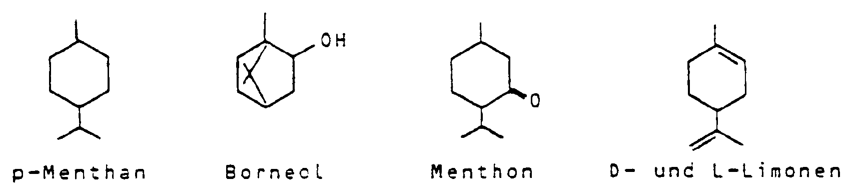 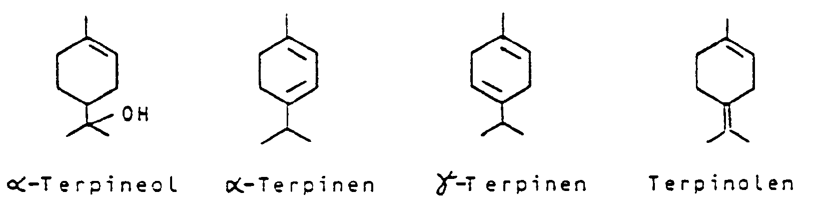 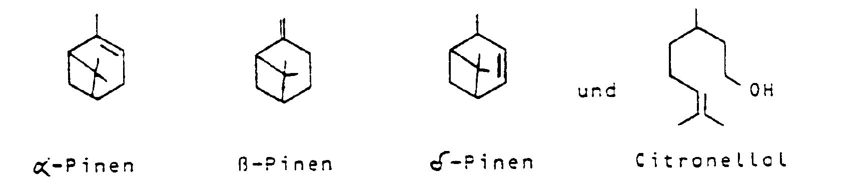 sowie Gemische aus diesen, wobei D- und L-Limonen bevorzugt und die aus Orangenschalen gewonnenen Gemische aus Isomeren des Limonens ganz besonders bevorzugt sind. Letztere werden im folgenden der Kürze halber als "Limonen" bezeichnet.

Zusätzlich zu den erfindungsgemäß anzuwendenden Monoterpenen können in den Entwicklerlösungsmitteln etwa bis zu 40 Gew.% an anderen Lösungsmitteln mitverwendet werden, z.B. die vom vorstehend angegebenen Stand der Technik her bekannten, insbesondere aber höhersiedende Alkohole in einer Menge von 20 Gew.%.

Methodisch bietet das erfindungsgemäße Verfahren keine Besonderheiten, d.h. man entwickelt die in üblicher Weise bildmäßig belichteten Schichten durch Auswaschen der unvernetzten Anteile der Schichten mit den erfindungsgemäß anzuwendenden Entwicklerlösungsmitteln in den bekannten Sprüh-, Bürsten- und Reibewaschern bei Temperaturen von 20 bis 60°C, insbesondere 25 bis 35°C. Dabei zeigt es sich, daß die optimalen Auswaschzeiten der erfindungsgemäßen Verfahrens deutlich kürzer sind als die der bekannten Verfahrensweisen und daß es dabei - im Gegensatz zu den bekannten Verfahrensweisen - beim Überschreiten der optimalen Auswaschzeiten nicht zur sogenannten Überwaschung, d.h. dem Herausbrechen von Material aus der Reliefform durch mechanische Einwirkung (Kantenausbruch), kommt. Unter optimaler Auswaschzeit ist dabei die Zeit zu verstehen, in der man beim Auswaschen gerade die maximale Relieftiefe erreicht. Gleichzeitig werden Reliefformen mit stärker ausgeprägter Tiefe und sehr gutem Flankenaufbau erhalten, wobei die Oberfläche dieser Reliefformen überraschenderweise deutlich glatter und gleichmäßiger ist als die Oberfläche von Reliefformen, welche nach den bekannten Verfahrensweisen hergestellt worden sind. Desgleichen ist die Quellung der Bildelemente deutlich geringer als bei der Verwendung üblicher Entwicklerlösungsmittel. Ein zusätzlicher überraschender Vorteil des erfindungsgemäßen Verfahrens ist, daß es - selbst nach längerem Betrieb - in den Waschern nicht zu Ablagerungen kommt.

Bei der Durchführung des erfindungsgemäßen Verfahrens geht dem Entwicklungsschritt eine bekannte und übliche bildmäßige Belichtung der durch Photopolymerisation vernetzbaren Schichten mit aktinischem LichteinerWellenlänge 9,van 230 bis 450, insbesondere 300 bis 450 nm voraus. Hierfür geeignete Lichtquellen sind z.B. die Strahlung der Sonne, handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Dem Entwicklungsschritt schließt sich im weiteren Ablauf des erfindungs-gemäßen Verfahrens die Trocknung der Reliefformen an. Anschließend können die Reliefformen noch in Halogen enthaltenden oder liefernden Bädern halogeniert, in reduzierenden Bädern nachgewaschen und erneut getrocknet werden. Alternativ oder im Nachgang zu dieser Behandlung können die Reliefformen noch mit aktinischem Licht vollflächig belichtet werden.

Ein weiterer Vorteil des erfindungsgemäßen Verfahrens ist es, daß es an zahlreichen bekannten, durch Photopolymerisation vernetzbaren Schichten, die in der Hauptsache
A) ein oder mehrere Bindemittel auf der Basis elastomerer Polymerisate,
B) ein oder mehrere hiermit verträgliche photopolymerisierbare Monomere und
C) einen oder mehrere Photoinitiatoren enthalten,
   mit gutem Erfolg ausgeführt werden kann.

Diese Schichten können noch weitere geeignete Zusätze wie Inhibitoren der thermisch initiierten Polymerisation, Farbstoffe, Pigmente, photochrome Stoffe, Lichthofschutzmittel, Weichmacher, Antioxidantien, Antiozonantien, Mittel zur Verbesserung der Reliefstruktur, Vernetzungshilfsmittel, Flußmittel, Trennmittel, Füllmittel und/oder Verstärkerfüllstoffe in wirksamen Mengen enthalten.

Das erfindungsgemäße Verfahren läßt sich mit sehr gutem Erfolg an Schichten, die als Bindemittel A Polymerisate von konjugierten aliphatischen Dienen mit 4 bis 5 Kohlenstoffatomen enthalten, ausführen. Vorteilhafte Bindemittel A sind beispielsweise Naturkautschuk, die Homopolymerisate von Butadien oder Isopren, Copolymerisate von Butadien mit Isopren oder Copolymerisate von Butadien und/oder Isopren mit anderen copolymerisierbaren Monomeren wie Styrol, a-Methylstyrol, Vinyltoluol, Acrylnitril oder (Meth)-Acrylsäurealkylestern mit 1 bis 8 C-Atomen in der Alkylgruppe, z.B. Nitrilkautschuke gemäß EP-A-64 564, statistische Styrol/Butadien-, -/Isopren- und -/Isopren/Butadien-Copolymerisate mit einem Gehalt an einpolymerisiertem Styrol von 10 bis 50 Gew.% oder Blockcopolymerisate aus Styrolmonomeren und Butadien und/oder Isopren gemäß DE-AS 22 15 090, DE-OS 24 56 439 und DE-OS 29 42 183. Von diesen sind die Blockcopolymerisate gemäß DE-OS 29 42 183 von besonderem Vorteil.

Das erfindungsgemäße Verfahren läßt sich mit ausgezeichnetem Erfolg an Schichten ausführen, die als Bindemittel A elastomere Dreiblockcopolymerisate des Typs X-Y Z gemäß DE-OS 29 42 183 enthalten, in denen X einen thermoplastischen, nicht elastischen Styrol-Polymerisat-Block, Y einen elastomeren Butadien-und/oder Isopropren-Polymerisat-Block und Z einen von Y verschiedenen elastomeren Polymerisat-Block aus Butadien und/oder Isopren sowie gegebenenfalls Styrol darstellt.

Das erfindungsgemäße Verfahren kann an den durch Photopolymerisation vernetzbaren Schichten als solchen oder an vernetzbaren Schichten, die im Verbund mit weiteren geeigneten flächenförmigen Schichten vorliegen, ausgeführtwerden. Verbunde dieser Artwerden allgemein als "Mehrschichtenelemente" bezeichnet (vgl. DE-OS 29 42 183, DE-OS 24 44 118).

Die nach dem erfindungsgemäßen Verfahren erhaltenen Reliefformen können als dekorative Oberflächen, als Photoresistmuster oder als Flach-, Hoch-und Flexodruckformen verwendet werden. Inbesondere eignen sie sich für Flexodruckformen für den Endlosdruck.

### Beispiele und Vergleichsversuche

In den folgenden Beispielen und Vergleichsversuchen wurde die Dickenquellung in % durch gravimetrische Messungen bestimmt. Die Güte des Flankenaufbaus der Bildelemente wurde visuell mit Hilfe eines Mikroskops ermittelt; Kriterien waren Steilheit und Grad der Unterhöhlung der Flanken sowie Grad derAbrundung der Kanten.

### Beispiel 1

Es wurde eine handelsübliche Flexodruckplatte in üblicher Weise hergestellt. Dabei diente als Trägerfolie eine 125 µm dicke Polyethylenterephthalatfolie, die vor dem Aufbringen der photovernetzbaren Schicht mit einer 0,3 µm dicken Polyurethan-Haftlackschicht beschichtet wurde. Die durch Photopolymerisation vernetzbare Schicht besaß eine Dicke von 700 µm und enthielt A) 90,917 Gew.% Blockcopolymerisat XYZ mit einer Viskositätszahl von 164,9 ml/g und einer Gesamtmolmasse von 190.000, bestehend aus, bezogen auf XYZ, 10 Gew.% Polystyrol als X-Block, 70 Gew.% Polyisopren einer Glastemperatur Tg von -53°C als Y Block und 20 Gew.% Polyisopren mit einem Gehaltvon 53 Gew.% an 3,4-Strukturen und einer Glastemperatur Tg von +10_{°}C als Z-Block, B) 7,268 Gew.% Hexandiol-1,6-diacrylat, C) 1,350 Gew.% Benzildimethylacetal und als Zusatzstoffe 0,457 Gew.% 2,6-Di-tert.-butyl-p-kresol und 0,008 Gew.% Solvent Black 3 (C.I. 26 150). Als Schutzschicht wurde eine 2 µm dicke Schicht aus Cyclokautschuk hohen Cyclisierungsgrades verwendet.

Diese Flexodruckplatte wurde zunächst während 2 Minuten von ihrer Rückseite her in einem Röhrenbelichter vollflächig vorbelichtet, anschließend durch eine der Schutzschicht aufgelegten Negativvorlage hindurch während 22 Minuten bildmäßig belichtet und bei 30°C in einem nicht explosionsgeschützten Reibewascher mit Limonen entwickelt. Die optimale Auswaschzeit betrug 4 Minuten. Der Flankenaufbau der Bildelemente war einwandfrei ausgebildet, eine Abrundung der Reliefkanten und eine Unterhöhlung der Flanken waren nicht zu beobachten. Die Dickenquellung betrug 1,65 %.

Die Flexodruckform wurde während 2 Stunden bei 80°C getrocknet, während 15 Stunden bei Raumtemperatur gelagert, einer üblichen Nachbehandlung mit einer wäßrigen Bromlösung unterzogen und erneut getrocknet.

Die nachbehandelte Flexodruckform wurde auf einen Druckzylinder in einem Flexodruckwerk aufgespannt und lieferte ausgezeichnete Druckergebnisse, die keinerlei Informationsverlust gegenüber der Negativvorlage aufwiesen.

### Beispiel 2

Es wurde wie in Beispiel 1 verfahren, nur daß anstelle des nicht explosionsgeschützten Reibewaschers ein nicht explosionsgeschützter Sprühwascher verwendet wurde. Die optimale Auswascheit betrug 4,5 Minuten. Die Güte des Flankenaufbaus, die Dickenquellung und die Qualität der Druckergebnisse waren identisch mit denen des Beispiels 1.

### Vergleichsversuch 1

Es wurde wie in Beispiel 1 verfahren, nur daß anstelle des Limonens Tetrachlorethylen verwendet wurde. Die optimale Auswaschzeit betrug 6,5 Minuten, die Dickenquellung lag bei 3 %.

### Vergleichsversuch 2

Es wurde wie in Beispiel 1 verfahren, nur das anstelle des Limonens Cyclohexan verwendet wurde und daß anstelle des nicht explosionsgeschützten Reibewaschers zwangsweise ein Reibewascher mit aufwendigem Explosionsschutz verwendet werden mußte. Die optimale Auswaschzeit betrug 6 Minuten, die Dickenquellung lag bei 6 %. Der Flankenaufbau der Bildelemente war unbefriedigend (Unterhöhlung, abgerundete Kanten).

### Beispiel 3

Es wurde wie in Beispiel 1 verfahren. Der Wascher enthielt 90 I Limonen, womit insgesamt 50 bildmäßig belichtete Flexodruckplatten des Formats 200 x 300 mm und einem unvernetzten Anteil von 78 % entwickelt wurden. Im Wascher wurden keine Ablagerungen und Verschmutzungen festgestellt.

### Vergleichsversuch 3

Es wurde wie in Beispiel 3 verfahren, nur daß anstelle des Limonens Tetrachlorethylen angewendet wurde. Dabei zeigten sich im Wascher am oberen Rande der Badflüssigkeit und an den Bürsten Ablagerungen und Verschmutzungen.

### Beispiel 4

Es wurde wie in Beispiel 1 verfahren, nur wurde 8 Minuten länger ausgewaschen, als es der optimalen Auswaschzeit von 4 Minuten entsprach. Trotzdem kam es zu keiner Überwaschung.

### Vergleichsversuch 4

Es wurde wie in Beispiel 4 verfahren, nur daß anstelle des Limonens Tetrachlorethylen verwendet wurde. Dabei trat Überwaschung auf, die sich vor allem durch Kantenausbrüche bemerkbar machte. Des weiteren waren die Flanken freistehender Reliefpunkte unterhöhlt.

## Patentansprüche

1. Verfahren zur Herstellung von durch Photopolymerisation vernetzten Flexodruckformen durch bildmäßiges Belichten von durch Photopolymerisation vernetzbaren Schichten von Flexodruckplatten mit aktinischem Licht und Auswaschen der unvernetzten Anteile der Schichten mit Entwicklerlösungsmitteln, wobei diese Schichten in der Hauptsache
A) ein oder mehrere Bindemittel auf der Basis elastomerer Polymerisate,
B) ein oder mehrere hiermit verträgliche photopolymerisierbare Monomere und
C) einen oder mehrere Photoinitiatoren enthalten,
dadurch gekennzeichnet, daß man hierzu Entwicklerlösungsmittel verwendet, die als wesentlichen Bestandteil Monoterpene enthalten.

2. Verfahren gemäß Anspruch 1, dadurch gekennzeichnet, daß man Entwicklerlösungsmittel verwendet, die als wesentlichen Bestandteil p-Menthan, Borneol, Menthon, D- und L-Limonen.a- Terpineol, a-Terpinen, δ-Terpinen, Terpinolena- , β-und δ-pinen und/oder Citronellol enthalten.

## Claims

1. A process for the production of a flexographic printing plate crosslinked by photopolymerization, by exposing layers of flexographic printing plate precursors which are crosslinkable by photopolymerization imagewise to actinic light and washing out the noncrosslinked parts of the layers with a developer, these layers containing mainly
A) one or more binders based on elastomeric polymers,
B) one or more photopolymerizable monomers which are compatible with these binders, and
C) one or more photoinitiators,
wherein the developer used for this purpose contains a monoterpene as an essential component.

2. A process as claimed in claim 1, wherein the developer used contains, as an essential component, p-menthane, borneol, menthone, D-limonene, L-limonene, a-terpineol, a-terpinene, 8-terpinene , terpinolene, a-pinene, ß-pinene, 8-pinene and/or citronellol.

## Revendications

1. Procédé de réalisation de formes flexographiques, réticulées par photopolymérisation, par l'exposition en conformité d'image de couches de plaques flexographiques réticulables par photopolymérisation à de la lumière actinique et lixiviation ou dépouillage des fractions non réticulées des couches à l'aide de solvants révélateurs ou développateurs, où ces couches contiennent, en substance,
A) un ou plusieurs liants à base de polymères élastomères,
B) un ou plusieurs monomères photopolymérisables compatibles avec ceux-ci
C) un ou plusieurs photoamorceurs,
caractérisé en ce qu'à cette fin, on utilise des solvants révélateurs ou développateurs qui contiennent, à titre de constituant essentiel, des monoterpènes.

2. Procédé suivant la revendication 1, caractérisé en ce que l'on utilise des solvants révélateurs ou développateurs qui contiennent du p-menthane, du bornéol, de la menthone, du D- et du L-limonène, de l'a-terpinéol, de l'a-terpinène, du y-terpinène, du terpinolène, de l'α, β- et â-pinéne et/ou du citronellol, à titre de constituant essentiel.
